(19) Europäisches Patentamt

European Patent Office

Office européen des brevets

(11) **EP 3 817 066 A1**

## (12) EUROPEAN PATENT APPLICATION

(43) Date of publication:
**05.05.2021 Bulletin 2021/18**

(21) Application number: **19206084.6**

(22) Date of filing: **30.10.2019**

(51) Int Cl.:
**H01L 29/423** (2006.01)    **H01L 29/739** (2006.01)
**H01L 29/78** (2006.01)    **H01L 29/06** (2006.01)
**H01L 29/10** (2006.01)    **H01L 29/40** (2006.01)
**H01L 29/417** (2006.01)

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Infineon Technologies Austria AG
9500 Villach (AT)**

(72) Inventors:
• MAHMOUD, Ahmed
81539 München (DE)
• POPESCU, Dan Horia
80882 München (DE)
• ROCHEL, Markus
01445 Radebeul (DE)

(74) Representative: **Westphal, Mussgnug
Patentanwälte & Partner mbB
Werinherstraße 79
81541 München (DE)**

## (54) SEMICONDUCTOR DEVICES

(57) A semiconductor device comprises a semiconductor body (100) comprising a first surface (101), a second surface (102) opposite to the first surface (101) in a vertical direction (y), an edge termination region (210), and an active region (220) arranged adjacent to the edge termination region (210) in a horizontal direction. The semiconductor device further comprises a plurality of transistor cells (30) at least partly integrated in the active region (220), each transistor cell (30) comprising a source region (31), a body region (32), and a drift region (35) separated from the source region (31) by the body region (32), a gate electrode (33) arranged in the active region (220) and dielectrically insulated from the body regions (32) of the plurality of transistor cells (30), and a circumferential electrically conducting layer (60) arranged above the first surface (101) and in the edge termination region (210). The electrically conducting layer (60) extends around and electrically contacts the gate electrode (33). A contact between the circumferential electrically conducting layer (60) and the gate electrode (33) is interrupted at least once along the perimeter of the gate electrode (33).

**FIG 13**

EP 3 817 066 A1

**Description**

TECHNICAL FIELD

The instant disclosure relates to semiconductor devices, in particular to semiconductor devices with an increased avalanche ruggedness.

BACKGROUND

Semiconductor devices such as insulated gate power transistor devices, e.g., power MOSFETs (Metal Oxide Semiconductor Field-Effect Transistors) or IGBTs (Insulated Gate Bipolar Transistors), are widely used as electronic switches in various types of electronic applications. A transistor device generally includes a drive input and an internal capacitance between different nodes of the drive input. The nodes of the drive input are usually referred to as gate node and source node, and the internal capacitance is usually referred to as gate-source capacitance. The transistor device switches on and off dependent on a charging state of the gate-source capacitance, wherein the transistor is in an on-state when the charging state is such that a voltage across the gate-source capacitance is higher than a threshold voltage of the transistor device and the transistor device is in an off-state when the voltage across the gate-source capacitance is below the threshold voltage.

In some applications, an avalanche capability during a turn-off operation of the transistor device is limited and stresses on the transistor device result in local defects. Such local defects may eventually lead to the failure of the device

It is desirable to provide a robust semiconductor device that has an increased avalanche capability without significantly impacting any of the main device characteristics.

SUMMARY

One example relates to a semiconductor device. The semiconductor device includes a semiconductor body including a first surface, a second surface opposite to the first surface in a vertical direction, an edge termination region, and an active region arranged adjacent to the edge termination region in a horizontal direction. The semiconductor device further includes a plurality of transistor cells at least partly integrated in the active region, each transistor cell including a source region, a body region, and a drift region separated from the source region by the body region, a gate electrode arranged in the active region and dielectrically insulated from the body regions of the plurality of transistor cells, and a circumferential electrically conducting layer arranged above the first surface and in the edge termination region. The electrically conducting layer extends around and electrically contacts the gate electrode. A contact between the circumferential electrically conducting layer and the gate electrode is interrupted at least once along the perimeter of the gate electrode.

One example relates to another semiconductor device. The semiconductor device includes a semiconductor body including a first surface, a second surface opposite to the first surface in a vertical direction, an edge termination region, and an active region arranged adjacent to the edge termination region in a horizontal direction. The semiconductor device further includes a plurality of transistor cells at least partly integrated in the active region, each transistor cell including a source region, a body region, a drift region separated from the source region by the body region, a gate electrode arranged in the active region and dielectrically insulated from the body of the plurality of transistor cells, an electrically conducting layer arranged above the first surface and in the edge termination region, and a plurality of contact plugs. The electrically conducting layer extends around and electrically contacts the gate electrode. Each of the plurality of contact plugs is configured to electrically contact the electrically conducting layer. The plurality of contact plugs includes at least two sub-groups, each sub-group including at least two contact plugs. Two neighboring contact plugs within each sub-group are arranged at a first distance from each other along a perimeter of the gate electrode. Along the perimeter of the gate electrode, two neighboring sub-groups are separated from each other by one of at least two contact plug free sections comprising no contact plugs, each contact plug free section having a length along the perimeter of the gate electrode that is greater than the first distance.

Examples are explained below with reference to the drawings. The drawings serve to illustrate certain principles, so that only aspects necessary for understanding these principles are illustrated. The drawings are not to scale. In the drawings the same reference characters denote like features.

BRIEF DESCRIPTION OF THE DRAWINGS

Figure 1 schematically illustrates a cross sectional view of a semiconductor body.

Figure 2 schematically illustrates an equivalent circuit diagram of a transistor device.

Figure 3 schematically illustrates another equivalent circuit diagram of a transistor device.

Figure 4 schematically illustrates a top view of a semiconductor device.

Figure 5 schematically illustrates the gate signal propagation in the semiconductor device of Figure 4.

Figure 6 schematically illustrates a cross sectional view of a semiconductor body according to one example.

Figure 7 schematically illustrates a cross sectional view of a semiconductor body according to another example.

Figure 8, including Figures 8A - 8I, schematically illustrates top views of semiconductor bodies of semiconductor devices according to different examples.

Figure 9 schematically illustrates the gate signal propagation in an exemplary semiconductor device.

Figure 10 schematically illustrates a cross sectional view of a semiconductor device according to one example.

Figure 11 schematically illustrates a cross sectional view of a semiconductor device according to another example.

Figure 12 schematically illustrates a cross sectional view of a semiconductor device according to another example.

Figure 13 schematically illustrates a top view of a semiconductor device according to one example.

Figure 14 schematically illustrates a top view of a semiconductor device according to another example.

DETAILED DESCRIPTION

In the following detailed description, reference is made to the accompanying drawings. The drawings form a part of the description and for the purpose of illustration show examples of how the invention may be used and implemented. It is to be understood that the features of the various embodiments described herein may be combined with each other, unless specifically noted otherwise.

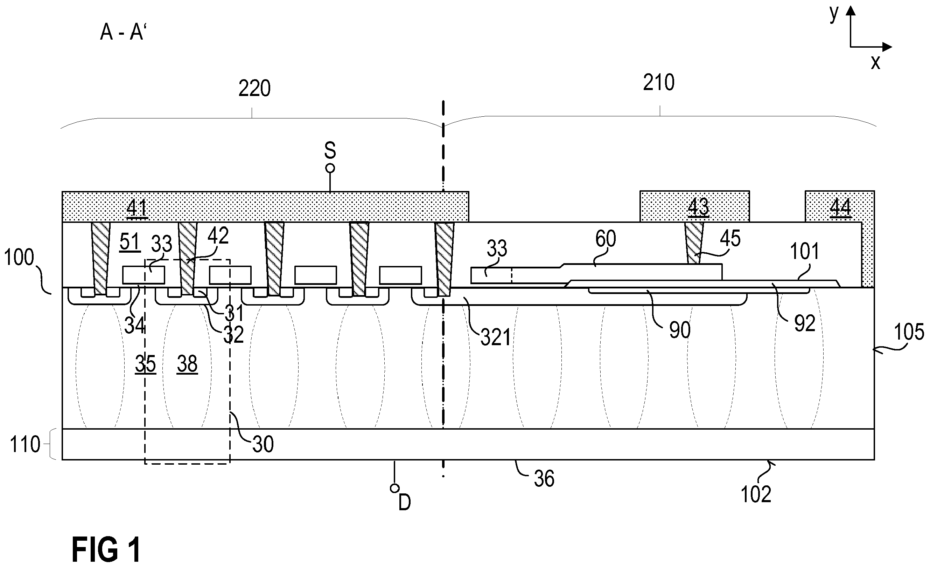

Referring to Figure 1, a cross-sectional view of a semiconductor device comprising a semiconductor body 100 is schematically illustrated. The semiconductor body 100 may include a conventional semiconductor material such as, for example, silicon (Si), silicon carbide (SiC), gallium nitride (GaN), gallium arsenide (GaAs), or the like. A transistor device is formed in the semiconductor body 100, the transistor device being arranged in an active region 220 of the semiconductor body 100. In Figure 1, only a small section of the transistor device is shown. In its active region 220, the semiconductor body 100 includes at least one working transistor cell 30 with a gate electrode 33 that is dielectrically insulated from a body region 32 by a gate dielectric 34. The body region 32 is a doped semiconductor region in the active region 220 of the semiconductor body 100. In the example illustrated in Figure 1, the body region 32 extends from a first surface 101 into the semiconductor body 100, and the gate electrode 33 is arranged above the first surface 101 of the semiconductor body 100.

The transistor device illustrated in Figure 1 further includes a drift region 35 formed in the semiconductor body 100. The drift region 35 adjoins the body region 32 of the at least one transistor cell 30 and forms a pn-junction with the body region 32. The drift region 35 is arranged between the body region 32 of the at least one transistor cell 30 and a semiconductor layer 110. The semiconductor layer 110 is arranged between a second surface 102 of the semiconductor body 100 and the drift region 35. The second surface 102 is arranged opposite to the first surface 101 in a vertical direction y of the semiconductor body 100.

The semiconductor layer 110 comprises a common drain region 36 of the same doping type as the drift region 35 and adjoining the second surface 102. The common drain region 36 is shared by the at least one transistor cell 30. A vertical field-stop-region (not specifically illustrated) of the same doping type as the drift region 35 and the drain region 36, but less highly doped than the drain region 36, may be arranged between the drift region 35 and the drain region 36. That is, the semiconductor layer 110 may be formed by the drain region 36 and the adjoining vertical field-stop-region. The vertical field-stop-region may be formed by a single layer or by a plurality of separate sub-layers, e.g., at least two sub-layers. Sub-layers that are arranged closer to the drift region 35 may be less highly doped than sub-layers that are arranged further away from the drift region 35. For example, a doping concentration of a sub-layer that is arranged adjacent to the drift region 35 may be selected from a range of between 1E15 and 5E16 cm$^{-3}$ or lower. A doping concentration of a first sub-layer that is arranged adjacent to the drain region 36 may be higher than a doping concentration of a sub-layer that is arranged horizontally above this first sub-layer. The doping concentration of the sub-layer that is arranged adjacent to the drain region 36, however, may be lower than a doping concentration of the drain region 36. Generally speaking, a doping concentration of the different sub-layers may increase from the drift region 35 towards the drain region 36. The semiconductor layer 110 comprising a vertical field-stop-region and a drain region 36, however, is only an example. According to another example (as illustrated in Figure 1), the semiconductor layer 110 is formed only by the drain region 36, that is, the drain region 36 may directly adjoin the drift region 35 and at least one compensation region 38, which will be described in further detail below.

Still referring to Figure 1, the transistor device includes at least one compensation region 38 of a doping type complementary to the doping type of the drift region 35. According to one example, the transistor device includes a plurality of transistor cells 30 and each transistor cell 30 includes a compensation region 38 adjoining the body region 32 of the respective transistor cell 30. In a vertical direction y of the semiconductor body 100, which is a direction perpendicular to the first surface 101 and to the second surface 102, the at least one compensation region 38 in the active region 220 extends from the body region 32 into the semiconductor body 100 towards the semiconductor layer 110.

Still referring to Figure 1, the transistor device further includes a source electrode 41. The source electrode 41 is electrically connected to the source region 31 and the body region 32 of the at least one transistor cell 30 by means of contact plugs 42. The contact plugs 42 may comprise at least one of tungsten, aluminum, copper, and a Ti/TiN barrier liner, for example. This source electrode 41 forms a source node S or is electrically connected to a source node S of the transistor device. The transistor device further includes a drain node D electrically connected to the drain region 36. A drain electrode electrically connected to the drain region 36 may form the drain node D or may be electrically connected to a drain node D of the transistor device. Such a drain electrode may comprise a first metallization layer adjacent and electrically connected to the drain region 36. However, such drain electrode is not explicitly illustrated in Figure 1.

The transistor device can be an n-type transistor device or a p-type transistor device. The device type is defined by the doping type of the source region 31. In an n-type transistor device, the source region 31 is an n-type region, the body region 32 is a p-type region, the drift region 35, which has a doping type complementary to the doping type of the body region 32, is an n-type region, and the at least one compensation region 38 is a p-type region. In a p-type transistor device, the source region 31 is a p-type region, the body region 32 is an n-type region, the drift region 35 is a p-type region, and the at least one compensation region 38 is an n-type region. The transistor device can be implemented as a MOSFET or as an IGBT, for example. In a MOSFET, the drain region 36 has the same doping type as the drift region 35, as has been described above, and in an IGBT the drain region 36 (which may also be referred to as collector region) has a doping type complementary to the doping type of the drift region 35. For example, a doping concentration of the drain region 36 is selected from a range of between 1E18 and 1E19 cm$^{-3}$, 1E18 and 1E20 cm$^{-3}$, or 1E18 and 1E21 cm$^{-3}$, doping concentrations of the drift region 35 and the compensation region 38 are selected from a range of between 1E15 and 5E17 cm$^{-3}$, and a doping concentration of the body region 32 is selected from between 5E16 cm$^{-3}$ and 5E17 cm$^{-3}$. The transistor cells 30 illustrated in the Figures are planar transistor cells. Implementing the transistor cells 30 as planar transistor cells, however, is only one example. According to another example, the transistor cells 30 are implemented as trench transistor cells. That is, the gate electrode 33 is arranged in a trench that extends from the first surface 101 into the semiconductor body 100.

In an IGBT, the source region 31 may also be referred to as emitter region, and the drain region 36 may be referred to as collector region. In the following, the respective regions will be referred to as source region 31 and drain region 36, irrespective of whether the transistor device is a MOSFET or an IGBT.

In the transistor device explained above, a plurality of transistor cells 30 is connected in parallel. That is, the source regions 31 of these transistor cells 30 are connected to the source node S, the common drain region 36 is connected to the drain node D, and the at least one gate electrode 33 is connected to a gate node G.

The source electrode 41 in the example of Figure 1 is not a continuous layer completely covering the semiconductor body 100. Referring to Figure 1, a gate runner 43, and a field plate electrode 44 may be arranged adjacent to the source electrode 41 in a horizontal direction x of the semiconductor body 100. The gate runner 43 may be a circumferential, electrically conducting layer that is configured to electrically couple the gate electrodes 33 to a gate pad (not specifically illustrated in Figure 1). The source electrode 41 and the field plate electrode 44 are not directly connected to each other but are spaced apart with a gap formed between the source electrode 41 and the field plate electrode 44. For example, the gate runner 43 may be arranged in the gap between the source electrode 41 and the field plate electrode 44. The source electrode 41 and the field plate electrode 44 are electrically connected to each other via a base region 321 and a junction termination region 90 formed in the semiconductor body 100.

The base region 321 may be a depletable semiconductor region, i.e. a semiconductor region which is already substantially depleted when in an off-state a reverse voltage is applied between the drain node D and the source node S, reversely biasing the pn-junctions formed between adjoining drift regions 35 and compensation regions 38 which is lower than a rated breakdown voltage of the semiconductor device. Due to using a depletable base region 321, or at least a partly depletable base region 321, a major part of an edge region 210 differs from the source potential at higher reverse voltage. Thus a reduction of the breakdown voltage may be avoided. "At least partly depletable" in this context refers to a base region 321 that is largely depletable. However, some sections of the base region 321 may not be depletable. For example, a section of the base region 321 which directly adjoins a contact plug 42 that electrically couples the base region 321 to the source electrode 41 may not be depletable. This is, because this contact region in some applications should not be pinched off. Therefore, the section forming the transition between the base region 321 and the contact plug may be more highly doped than other sections of the base region 321 that are arranged further away from the contact plug 42. For example, a doping concentration of the base region 321 may decrease in the horizontal direction x from the contact plug 42 towards a horizontal edge (outer edge) 105 of the semiconductor body 100.

The base region 321 may be of the same doping type as the body regions 32. The doping concentration of the base region 321 is typically chosen such that the base region 321 is substantially depleted only above high enough reverse voltages of e.g. at least about a fifth or half of a rated breakdown voltage which is applied between the source node S and the drain node D. As has been described above, this may not be applicable for the section of the base region 321 which may be more highly doped and, therefore, may not be depletable at all. The junction termination region 90 may also be a depletable region. The junction termination region 90 may be of the opposite doping type than the body regions 32 and the base region 321 and may form a pn-junction with the base region 321. The base region 321 may extend from the first surface 101 into the semiconductor body 100 and may have a larger width in the horizontal direction x as compared to the body regions 32. The junction termination region 90 may also extend from the first surface 101 into the semiconductor body 100, a first section of the junction termination region 90 being arranged between the first surface 101 and the base region 321. A vertically integrated dopant concentration of the junction termination region 90 may match or may be lower than a vertically integrated dopant concentration of the base region 321. The junction termination region 90 may stabilize the edge region 210 against surface charges on the first surface 101.

The source electrode 41 is electrically connected to the base region 321 by means of a contact plug 42, and the field plate electrode 44 may be electrically connected to the junction termination region 90 by means of another contact plug (not specifically illustrated). The contact plugs, similar to the contact plugs 42 connecting the source electrode 41 and the body regions 32, may comprise at least one of tungsten, aluminum, polysilicon, copper, and a Ti/TiN barrier liner, for example.

According to other examples, the field plate electrode 44 may be replaced by one or more floating field plate electrodes (not illustrated). Such floating field plate electrodes may be formed from polycrystalline semiconductor material, for example, and may not be electrically connected to any of the other elements of the semiconductor device.

The contact plugs 42 that are arranged below the source electrode 41 and, optionally, below the field plate electrode 44 extend from the source and body regions 31, 32, or from the junction termination region 90 through an insulation layer 51 that is formed on the top surface 101 of the semiconductor body 100 to the source electrode 41, or the field plate electrode 44 to electrically couple the source and body regions 31, 32 to the source electrode 41, and the junction termination region 90 to the field plate electrode 44, respectively. In Figure 1, the insulation layer 51 is illustrated as a single continuous layer which extends from the first surface 101 of the semiconductor body 100 to the source electrode 41, the gate runner 43, and the field plate electrode 44. This, however, is only an example. Often, a gate oxide layer with a thickness of, e.g., 5nm to 200nm or 40nm to 120nm, is arranged on the first surface 101 of the semiconductor body 100. The insulation layer 51 may comprise this gate oxide layer and an additional layer which is formed on top of this gate oxide layer. This additional layer may comprise an undoped TEOS (tetraethyl orthosilicate) which may have a thickness of about 50nm to 500nm, and a doped BPSG (borophosphosilicate glass) having a thickness of about 200nm to 2$\mu$m or 1100nm to 1300nm, for example. The insulation layer 51, therefore, may comprise several sub-layers. A field oxide layer 92 that is arranged between the first surface 101 and the insulation layer 51 in an edge region 210 is schematically illustrated in Figure 1. Floating field plate electrodes may be arranged within the insulation layer 51 and may be completely surrounded by the material of the insulation layer 51, for example.

A semiconductor body 100 usually comprises not only an active region 220, but also an inactive region, also referred to as passive region or edge (termination) region 210. The semiconductor arrangement, that is, the plurality of transistor cells 30, may be implemented within the active region 220 of the semiconductor body 100. An edge region 210, e.g., may be a region adjacent to the horizontal edges (outer edges) 105 of the semiconductor body 100. The outer edges 105 extend in the vertical direction y between the first surface 101 and the second surface 102 and are essentially perpendicular to the first surface 101 and the second surface 102. A semiconductor body 100 having a rectangular or square cross section, for example, generally comprises four outer edges 105. According to one example, the active region 220 is horizontally surrounded by the edge region 210. The edge region 210 generally does not comprise any working transistor cells 30. In particular, an edge region 210 may be a region that does not include all active components that are necessary to form a functioning (working) transistor cell 30. Active components are, e.g., gate oxide, source regions 31, body regions 32, a gate electrode 33, or drain regions 36. For example, the edge region 210 may be a region within the semiconductor body 100 which does not comprise any source regions 31.

The source electrode 41 may be arranged on the active region 220 of the semiconductor body 100. A field plate electrode, such as the field plate electrode 44, for example, may be arranged on the edge region 210 of the semiconductor body 100. Optional floating field plate electrodes may also be arranged on the edge region 210. Generally speaking, conductive field plates 44 may be used on the edge region 210 of the semiconductor body 100 in order to spread the electric field more uniformly in the edge region 210. Such field plates 44 may be electrically connected to the underlying pillars formed by the drift regions 35 and the compensation regions 38, such that they can assume the potential of the corresponding pillars. As has been described above, it is however also possible to use floating field plates that are not electrically connected to the underlying pillars or to any other elements of the semiconductor device. As is illustrated in Figure 1, the termination field plate electrode 44 may be arranged adjacent to an outer edge 105 of the edge region 210. The termination field plate electrode 44 may be electrically connected to the junction termination region 90. Such field plates are generally known and will, therefore, not be described in further detail herein.

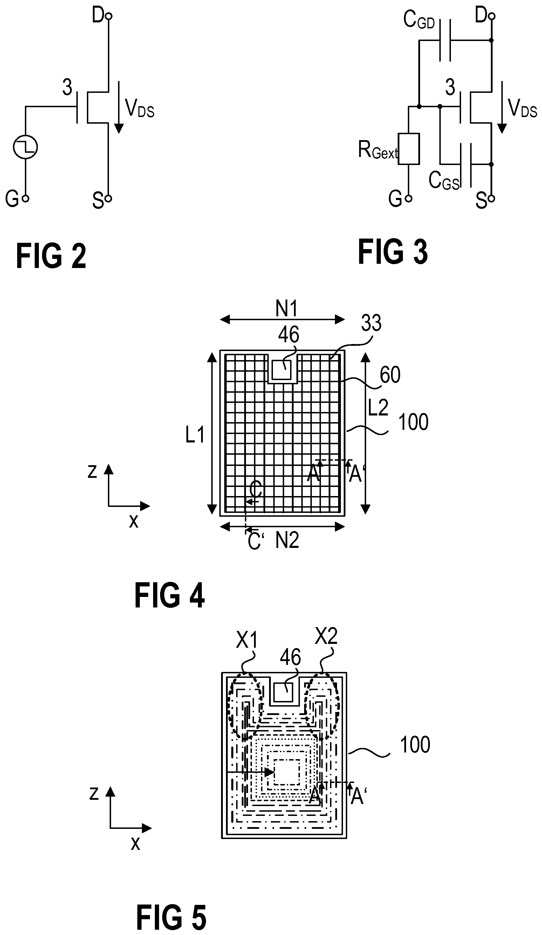

The gate electrodes 33 of the individual transistor cells 30 generally are elongated regions having a width in the first horizontal direction x that is significantly smaller than a length of the regions in a second horizontal direction z, the second horizontal direction z being perpendicular to the first horizontal direction x. This is schematically illustrated in the top view illustrated in Figure 4. The individual gate electrodes 33 are electrically coupled to each other by means of "crossbars". Usually, during production of the semiconductor device, a single continuous gate electrode 33 is formed above the first surface 101 of the semiconductor body 100. Such a gate electrode 33 may initially have a polygonal shape. In a further step, parts of the gate electrode 33 may be removed (e.g., in an etching step) in order to form openings in the gate electrode 33. The contact plugs 42 may extend from the first surface 101 of the semiconductor body towards the source electrode 41 through these openings, for example. In this way, a grid-like gate electrode 33 may result, as is schematically illustrated in Figure 4. As can be seen, the gate electrode 33 may either be described as a single common gate electrode 33 that is shared by the at least one transistor cell 30. It is, however, also possible to describe the gate electrode as a plurality of separate gate electrodes 33 that are electrically coupled to each other by a plurality of crossbars. In the following, the gate electrode 33 is regarded as a single gate electrode 33 that is common to all of the plurality of transistor cells 30.

As is illustrated in Figures 1 and 4, the gate electrode 33 is surrounded by a circumferential electrically conducting layer 60. The electrically conducting layer 60, according to one example, comprises a polycrystalline semiconductor material. For example, the electrically conductive layer 60 may comprise the same material as the gate electrode 33. The electrically conducting layer 60, as is illustrated in Figure 1, is arranged above the first surface 101 and in the edge region 210. The electrically conducting layer extends around the gate electrode 33 once, thereby forming a closed ring or loop around the gate electrode 33. The electrically conducting layer 60 electrically contacts (is electrically coupled to) the gate electrode 33. The electrically conducting layer 60 may be arranged at least partly below the gate runner 43 in a vertical direction y. Contact plugs 45 are provided to form an electrical connection between the electrically conducting layer 60 and the gate runner 43. The gate runner 43 is further electrically coupled to a gate pad 46, as is illustrated in the top view of Figure 4. The gate pad 46 may be arranged on a top surface of the insulation layer 51. The gate pad 46 may be arranged along one of the narrow sides N1 of the semiconductor body 100, for example (see, Figure 4). This, however, is only an example. The gate pad 46 may also be arranged in another other positions on the semiconductor body 100. The gate electrode 33 may be removed from regions that are arranged vertically below the gate pad 46, as is schematically illustrated in the top view of Figure 4. This may result in a polygonal gate electrode 33.

The cross-sectional view illustrated in Figure 1 is a cross-section along a section plane A - A' as illustrated in Figure 4. That is, Figure 1 illustrates a cross-section perpendicular to one of the longitudinal sides L2 of the semiconductor body 100.

Figure 2 schematically illustrates an equivalent circuit diagram of a transistor device 3. The transistor device 3 comprises a drain node D and a source node S with a load path formed between the drain node D and the source node S. The transistor device 30 further comprises a gate node G. The gate node G may be electrically coupled to the gate of the transistor device 3. A transistor device 3 as illustrated in Figure 1, includes an internal capacitance $C_{GS}$ between its gate node G and its source node S. This internal capacitance $C_{GS}$ is usually referred to as gate-source capacitance and is schematically illustrated in the equivalent circuit diagram in Figure 3. A transistor device 3 further includes an internal capacitance $C_{GD}$ between its gate node G and its drain node D. This internal capacitance $C_{GD}$ is usually referred to as gate-drain capacitance (see Figure 3). The transistor device 3 switches on and off dependent on a charging state of the gate-source capacitance $C_{GS}$, wherein the transistor device 3 is in an on-state when the charging state is such that a voltage across the gate-source capacitance $C_{GS}$ is higher than a threshold voltage of the transistor device 3, and the transistor device 3 is in an off-state when the voltage across the gate-source capacitance $C_{GS}$ is below the threshold voltage.

Generally, the following applies:

$$I = C_{GD} dV_{GD}/dt \qquad\qquad (1),$$

and

$$V_{GS} = R_{Gext} C_{GD} \frac{dV_{GD}}{dt} \left\{ 1 - exp \frac{-t}{R_{Gext}(C_{GS}+C_{GD})} \right\} \qquad (2),$$

wherein $C_{GS}$ is the gate-source capacitance, $C_{GD}$ is the gate-drain capacitance, $R_{Gext}$ is an external resistor between the gate node G and the gate-source capacitance $C_{GS}$, and $V_{GD}$ is a voltage between the gate node G and the drain node D.

A switching speed, that is, how fast the transistor device 3 switches from the off-state to the on-state, and vice versa, is dependent on how fast the gate-source capacitance $C_{GS}$ charges or discharges when the drive voltage changes. This switching speed can generally be adjusted by providing an external resistor $R_{Gext}$ between the gate node G and the gate-source capacitance $C_{GS}$. A different electrical resistance of the resistor $R_{Gext}$ results in a different switching speed. A control signal provided at the gate node G propagates from the gate pad 46 through the gate runner 43 and from the gate runner 43 further through the contact plugs 45 and the electrically conducting layer 60 to the gate electrode 33. As is schematically illustrated in the top view of Figure 5, a control signal generally propagates in the gate electrode 33 from the outer periphery towards a central area of the gate electrode 33. That is, the control signal propagates from the electrically conducting layer 60 towards a central area of the gate electrode 33. The propagation of the control signal within the gate electrode 33 is illustrated with different dot-dashed and dashed lines in Figure 5.

As has been described above, the gate electrode 33 does not necessarily have a rectangular cross-section. Due to the fact that the gate electrode 33 is not arranged in regions below the gate pad 46, this may result in a polygonal gate electrode 33 having protruding regions X1, X2 that prevent a homogenous propagation of the control signal in the gate electrode 33. The protruding regions X1, X2 arranged next to (close to) the gate pad 46 may receive the control signal earlier than other regions of the gate electrode 33.

Instead of or in addition to adjusting the switching speed by means of an external resistor $R_{Gext}$, an internal resistance between the electrically conducting layer 60 and the gate electrode 33 may be locally increased in order to homogenize the propagation of the control signal in the gate electrode 33.

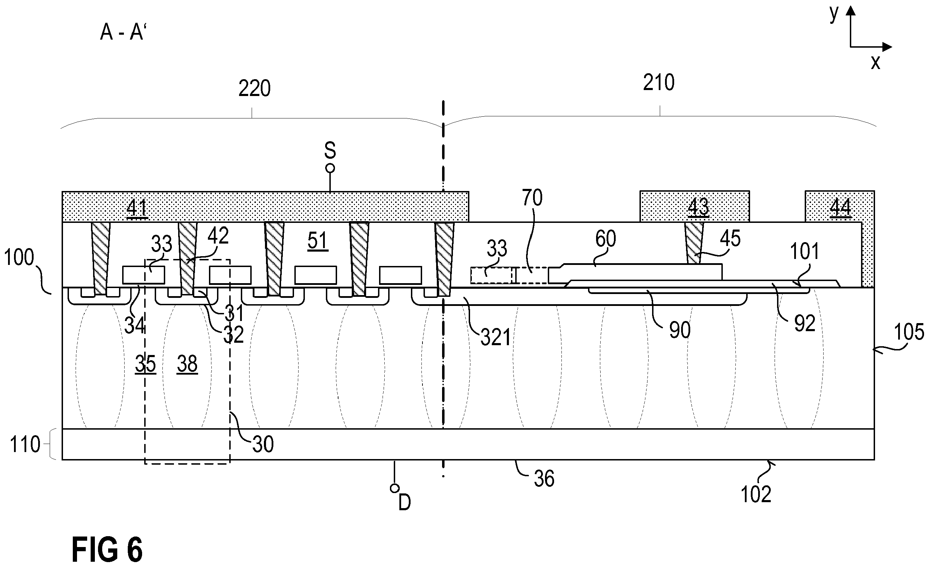

Now referring to Figure 6, an increase of the internal resistance between the electrically conducting layer 60 and the gate electrode 33 may be achieved by locally interrupting a contact between the electrically conducting layer 60 and the gate electrode 33. That is, at least once along the perimeter of the gate electrode 33, a contact between the electrically conducting layer 60 and the gate electrode 33 may be interrupted. Instead, a layer of dielectrically insulating material 70 is arranged horizontally between the electrically conductive layer 60 and the gate electrode 33. This dielectrically insulating layer 70 locally interrupts an electrical contact between the electrically conducting layer 60 and the gate electrode 33. In those regions, where the contact between the electrically conducting layer 60 and the gate electrode 33 is interrupted, the control signal cannot propagate directly from the electrically conducting layer 60 to the adjacent regions of the gate electrode 33. The control signal rather needs to bypass the dielectrically insulating layer 70 and propagate from the electrically conducting layer 60 to the gate electrode 33 in another point along the perimeter of the gate electrode 33. The region of the gate electrode 33 that is arranged adjacent to the dielectrically insulating layer 70 receives the control signal via other regions of the gate electrode 33. The course the control signal needs to travel to certain regions of the gate electrode 33 therefore increases, which results in a local increase of the resulting internal resistance.

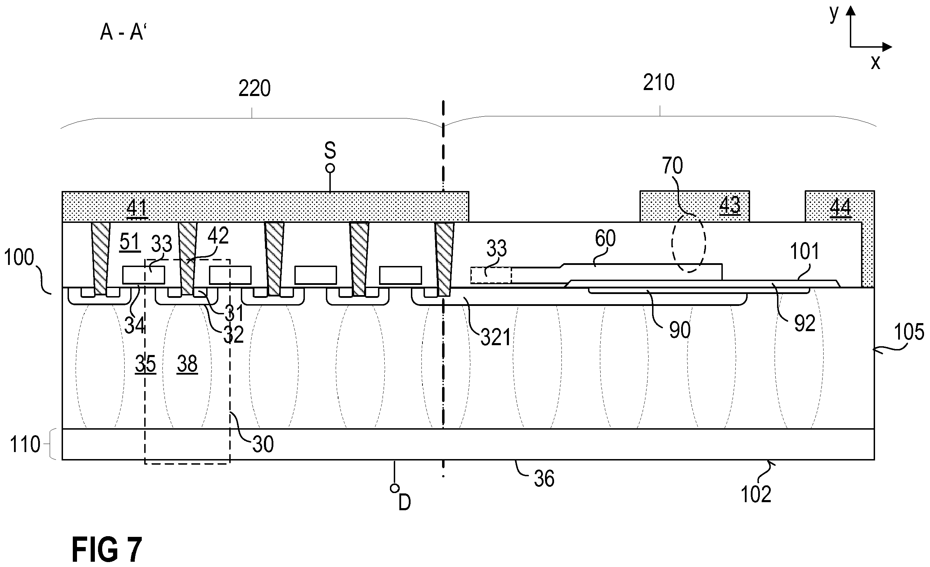

Instead of locally interrupting a contact between the electrically conducting layer 60 and the gate electrode 33, it is also possible to omit the contact plugs 45 extending between the gate runner 43 and the electrically conductive layer 60 at least in one contact free section along the perimeter of the gate electrode 33. This will be described in further detail with respect to Figures 7, 10 and 14 further below.

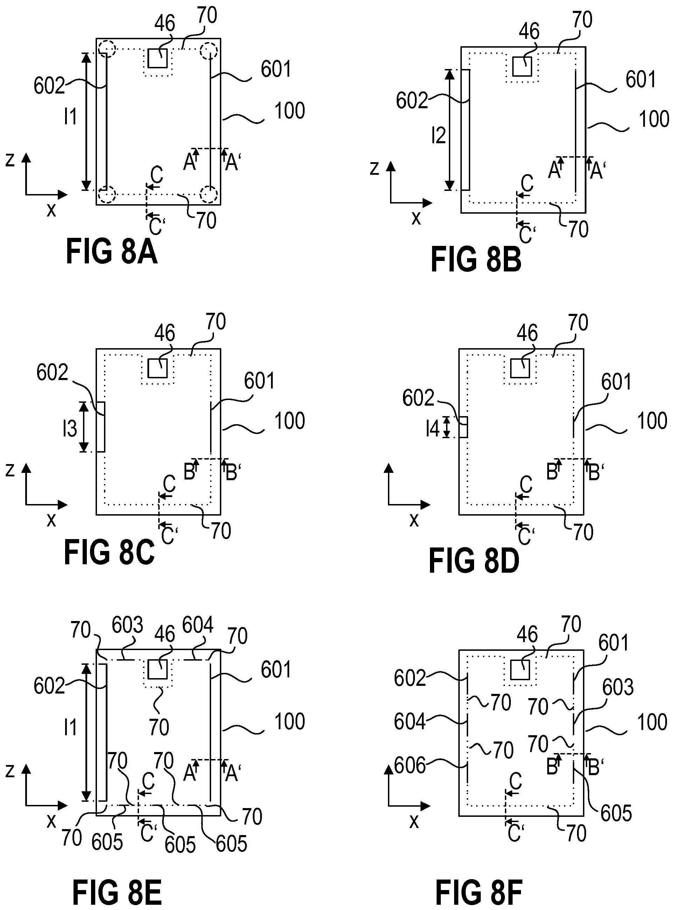

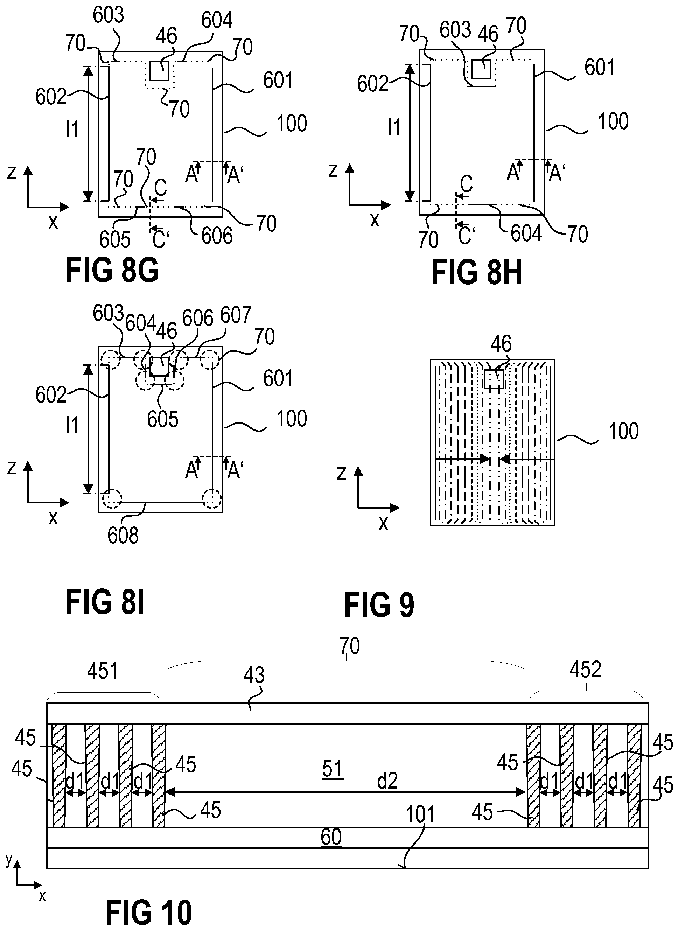

Now referring to Figure 8, different exemplary semiconductor devices are schematically illustrated. The top view in Figure 8A illustrates an exemplary semiconductor device wherein a contact between the electrically conductive layer 60 and the gate electrode 33 is interrupted along the narrow sides N1, N2 of the semiconductor body. The contact may further be interrupted in the range of the corners of the gate electrode 33 (marked in dashed circles in Figure 8A). In this way, the control signal propagates through the gate runner 43 and through the contact plugs 45 towards the electrically conducting layer 60. As the contact between the electrically conductive layer 60 and the gate electrode 33 is interrupted along the narrow sides N1, N2, the control signal propagates from the electrically conducting layer 60 to the gate electrode 33 only along the longitudinal sides L1, L2. In the example illustrated in Figure 8A, the length 11 of contact areas 601, 602 along which the electrically conductive layer 60 contacts the gate electrode 33 essentially equals a maximum length of the gate electrode 33 in this second horizontal direction z. This, however, is only an example.

According to the example illustrated in Figure 8B, a contact between the electrically conducting layer 60 and the gate electrode 33 may further be interrupted at least partly along the longitudinal sides L1, L2 of the semiconductor body 100. That is, a length 12 of contact areas 601, 601 along which the electrically conductive layer 60 contacts the gate electrode 33 may be less than a maximum length of the gate electrode 33 in this second horizontal direction z (12 < 11). This length may be reduced even further as is illustrated in Figures 8C (13 < 12 < 11) and 8D (14 < 13 < 12 < 11). That is, a length of one or more contact areas 601, 602 between the electrically conducting layer 60 and the gate electrode 33 along the longitudinal sides L1, L2 may be significantly reduced.

Now referring to Figure 8E, it is also possible that one or more contact areas 603, 604, 605 remain along the narrow sides N1, N2 of the semiconductor body 100. For example, a contact between the electrically conducting layer 60 and the gate electrode 33 may be interrupted in the range of the corners of the gate electrode 33 as well as in other regions along the narrow sides N1, N2. Even further, as is illustrated in Figure 8F, it is also possible to provide more than one contact area 601, 602, 603, 605, 605, 606 long the longitudinal sides L1, L2 of the semiconductor body 100. Further possible examples are illustrated in Figures 8G, 8H and 8I.

A section of a layer of dielectrically insulating material 70 may be formed between two neighboring contact areas 60n along the perimeter of the gate electrode 33 in order to locally interrupt a contact between the electrically conducting layer 60 and the gate electrode 33. On the other hand, along the perimeter of the gate electrode 33, separate sections of the dielectrically insulating layer 70 are separated from each other by portions of the electrically conducting layer 60. According to one example, at least one of the separate sections of the dielectrically insulating layer 70 may be arranged at one of the at least four corners of the polygonal gate electrode 33 and may be configured to interrupt a contact between the respective corner of the gate electrode 33 and the electrically conducting layer 60. Additionally or alternatively, at least one of the separate sections of the dielectrically insulating layer 70 may extend along the perimeter of the gate electrode 33 between two of the at least four corners of the polygonal gate electrode 33.

In this way, the propagation of the control signal in the gate electrode 33 may be homogenized. This is schematically illustrated in Figure 9. The propagation of the control signal within the gate electrode 33 is illustrated in dot-dashed and dashed lines in Figure 9. As can be seen, in this example the control signal propagates evenly from both longitudinal sides L1, L2 towards a central region (central line) of the gate electrode 33. This central region (central line) may represent an axis of symmetry with regard to the control signal propagation. The propagation illustrated in Figure 9 may, for example, represent the propagation of the control signal in the arrangement of Figure 8A. As can be seen and in contrast to the propagation illustrated in Figure 5, in the protruding regions X1, X2 arranged next to the gate pad 46, the propagation is also even from the longitudinal sides L1, L2 of the semiconductor body 100 towards the gate pad 46.

The arrangements in Figure 8A to 8I, however, are merely examples. Any other number of contact areas 60n, as well as any other suitable size (length along the perimeter of the gate electrode 33) and/or distribution of the at least one contact area 60n along the perimeter of the gate electrode 33 is possible. The number of contact areas 60n, as well as the size (length along the perimeter of the gate electrode 33) and distribution of the at least one contact area 60n may, for example, depend on the overall design of the semiconductor device. For example, if the gate pad 46 is arranged in a corner of the semiconductor body 100, the number, size and distribution of the contact areas 60n may be different as compared to the examples illustrated in Figure 8. Further, the number, size and distribution of the contact areas 60n may depend on the size and the form of the gate pad 46 or even on the specific application for which the semiconductor device is to be used. Generally speaking, the contact between the circumferential electrically conducting layer 60 and the gate electrode 33 may be interrupted at least once along the perimeter of the gate electrode 33 in order to alter a propagation of the control signal as compared to a semiconductor device with a continuous electrical contact along the perimeter of the gate electrode 33.

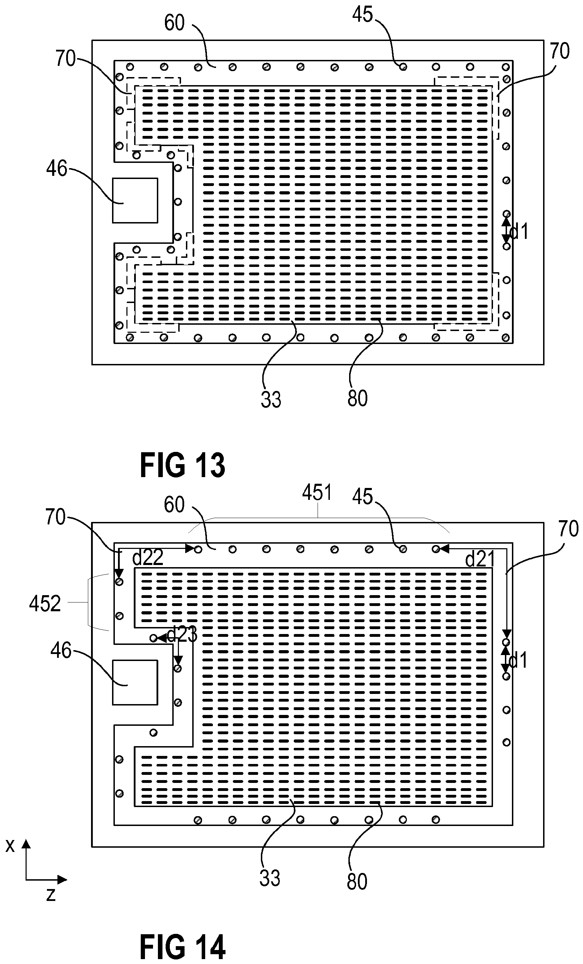

A more detailed view of an exemplary semiconductor device is illustrated in Figure 13. In the top view of Figure 13, the grid-like gate electrode 33 is schematically illustrated (white, with the openings in the gate electrode 33 marked with short black lines). Further, the circumferential electrically conducting layer 60 as well as the contact plugs 45 are illustrated. The electrically conducting layer 60 forms a continuous band around the perimeter of the gate electrode 33. The electrically conducting layer 60 has a certain width in a horizontal direction x, z between the gate electrode 33 and the 105 outer edges 105 of the semiconductor body 100. This width may be locally reduced by providing interruptions of the contact between the gate electrode 33 and the electrically conducting layer 60. In the example illustrated in Figure 13, interruptions are introduced in particular in the range of the corners of the gate electrode 33. Interruptions may be formed by removing material of the electrically conducting layer 60 (e.g., using an etching process). After removing material of the electrically conducting layer 60, the resulting areas may be filled with a dielectrically insulating material to form a layer of dielectrically insulating material 70.

The plurality of contact plugs 45 extending between the electrically conducting layer 60 and the gate runner 43 is arranged at regular intervals d1 around the perimeter of the gate electrode 33. That is, each contact plug 45 is arranged at a first distance d1 from each of its neighboring contact plugs 45 (see Figure 13).

As has been mentioned above, locally interrupting a contact between the electrically conducting layer 60 and the gate electrode 33 is only one way to locally increase a resistance between the gate pad 46 and the gate electrode 33. According to another example, as is schematically illustrated in Figures 7, 10 and 14, it is alternatively possible to locally omit the contact plugs 45 that electrically couple the electrically conducting layer 60 to the gate runner 43. That is, the plurality of contact plugs 45 comprises at least two sub-groups 451, 452 (see, e.g., Figure 10). Each of the at least two sub-groups 451, 452 comprises at least two contact plugs 45. Within each of the sub-groups 451, 452, two neighboring contact plugs 45 are arranged at a first distance d1 from each other along the perimeter of the gate-electrode 33. Two-neighboring sub-groups 451, 452, on the other hand, are separated from each other by a contact plug free section 70. For example, if the contact plugs 45 are arranged in two separate sub-groups 451, 452, there are two contact plug free sections 70 separating the sub-groups 451, 452 from each other. Each contact plug free section 70 does not comprise any contact plugs 45 that electrically couple the electrically conducting layer 60 to the gate runner 43. Each contact plug free section 70 has a length d21, d22, d23, d2n along the perimeter of the gate electrode 33 that is greater than the first distance d1.

In the cross-sectional view illustrated in Figure 10, only a small section along the perimeter of the gate electrode 33 is shown with two sub-groups 451, 452 of contact plugs 45 and a contact plug free section 70 separating the two sub-groups 451, 452. In the top view illustrated in Figure 14, more than two sub-groups 45n and more than two contact plug free sections 70 are illustrated along the perimeter of the gate electrode 33. Generally, there may be at least two sub-groups 451, 452, and at least two contact plug free sections 70 separating the different sub-groups 451, 452 from each other.

Similar to the example illustrated in Figures 6 and 13 above, the resistance between the gate pad 46 and the gate electrode 33 is locally increased. For those regions of the gate electrode 33 that are arranged adjacent to a contact plug free section 70, a control signal is forced to propagate along a different path as compared to an arrangement comprising no contact free section 70. In particular, the control signal cannot propagate directly from the gate runner 43 through the contact plugs 45 and the electrically conducting layer 60 to certain parts of the gate electrode 33. The control signal rather needs to pass from the gate runner 43 through contact plugs 45 that are arranged distant to the contact plug free sections 70 and further through the electrically conducting layer 60 along the perimeter of the gate electrode 33 to those regions of the gate electrode 33 that are arranged adjacent to the contact plug free sections 70.

The arrangement of different sub-groups 45n of contact plugs 45 and different contact plug free sections 70 may be similar to the arrangement of the sections of the dielectrically insulating layer 70 and of the contact areas 60n, as has been described with respect to Figure 8 above. That is, for example, contact plug free sections 70 may be arranged in the range of the corners of a polygonal gate electrode 33. According to another example, contact plug free sections 70 may be, additionally or alternatively, arranged along the narrow sides N1, N2 of a polygonal gate electrode 33 as schematically illustrated in Figure 8. Any other suitable arrangements are possible.

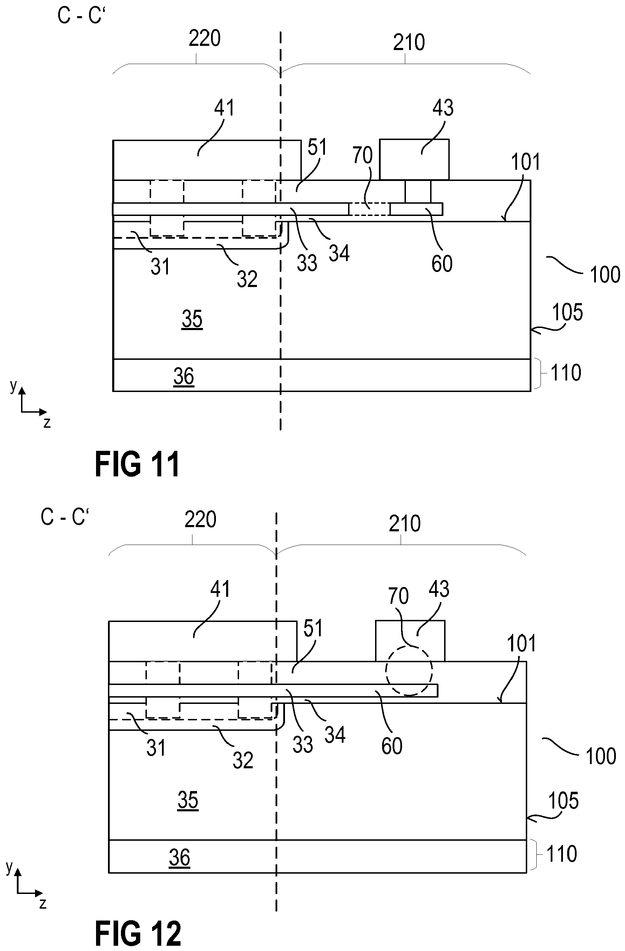

Now referring to Figures 11 and 12, cross-sectional views of the semiconductor devices of Figures 6 and 7 in a section plane C-C' (see, e.g., Figure 8) are schematically illustrated. Figures 11 and 12 schematically illustrate a cross-sectional views of a planar transistor device. Referring to Figures 11 and 12 and as has been described above, the gate electrode 33 of the transistor device may comprise a plurality of longitudinal semiconductor regions. A length of such regions of the gate electrodes 33 in the second horizontal direction z may be considerably larger than a respective width in the first horizontal direction x, the horizontal directions x, z being perpendicular to each other. The different regions of the gate electrodes 33 may have an elongated form that is similar to the form of the compensation regions 38, as illustrated in Figure 4. The gate electrode 33 is electrically connected to the gate runner 43 via the electrically conducting layer 60 surrounding the gate electrode 33. The gate runner 43 is a circumferential, electrically conducting layer which electrically couples the gate electrode 33 to the gate pad 46 (gate pad 46 not illustrated in Figures 11 and 12). In the examples illustrated in Figures 11 and 12, the gate runner 43 at least partly overlaps the electrically conducting layer 60. That is, the electrically conducting layer 60 is at least partly located below the gate runner 43 in the vertical direction y. According to one example, the electrically conducting layer 60 is electrically coupled to the gate runner 43 by means of contact plugs 45 that are arranged in regular intervals along the perimeter of the gate electrode 33.

As is illustrated in Figure 11 and as has been described with respect to Figures 6 and 13 above, a contact between the electrically conducting layer 60 and the gate electrode 33 may be locally interrupted along the perimeter of the gate electrode 33.

However, as has been described with respect to Figures 7 and 14 above and as is illustrated in Figure 12, it is also possible that in some contact plug free sections 70 the electrically conducting layer 60 is not directly connected to the gate runner 43. "Not directly connected" in this context means that there is no contact plug 45 between the contact plug free section 70 of the electrically conducting layer 60 and the gate runner 43. However, such contact plug free sections 70 of the electrically conducting layer 60 may still be indirectly connected to the gate runner 43 via another section of the electrically conducting layer 60 and one or more contact plugs 45 that are arranged in one of the at least two sub-groups 451, 452 of contact plugs 45.

**Claims**

1. A semiconductor device, comprising:

    a semiconductor body (100) comprising a first surface (101), a second surface (102) opposite to the first surface

(101) in a vertical direction (y), an edge termination region (210), and an active region (220) arranged adjacent to the edge termination region (210) in a horizontal direction;

a plurality of transistor cells (30) at least partly integrated in the active region (220), each transistor cell (30) comprising a source region (31), a body region (32), and a drift region (35) separated from the source region (31) by the body region (32);

a gate electrode (33) arranged in the active region (220) and dielectrically insulated from the body regions (32) of the plurality of transistor cells (30); and

a circumferential electrically conducting layer (60) arranged above the first surface (101) and in the edge termination region (210), wherein the electrically conducting layer (60) extends around and electrically contacts the gate

electrode (33), and a contact between the circumferential electrically conducting layer (60) and the gate electrode (33) is interrupted at least once along the perimeter of the gate electrode (33).

2. The semiconductor device of claim 1, further comprising a layer of dielectrically insulating material (70) arranged horizontally between the circumferential electrically conducting layer (60) and the gate electrode (33) and configured to interrupt a contact between the circumferential electrically conducting layer (60) and the gate electrode (33).

3. The semiconductor device of claim 2, wherein the gate electrode (33) has a polygonal perimeter comprising at least four corners, wherein the dielectrically insulating layer (70) comprises at least two separate sections, each of the two separate sections extending along a section of the perimeter of the gate electrode (33), and wherein at least one of the following

at least one of the separate sections of the dielectrically insulating layer (70) is arranged at one of the at least four corners of the gate electrode (33) and is configured to interrupt a contact between the respective corner of the gate electrode (33) and the electrically conducting layer (60); and

at least one of the separate sections of the dielectrically insulating layer (70) extends along the perimeter of the gate electrode (33) between two of the at least four corners.

4. The semiconductor device of claim 3, wherein, along the perimeter of the gate electrode (33), the separate sections of the dielectrically insulating layer (70) are separated from each other by portions of the electrically conducting layer (60).

5. The semiconductor device of any of the preceding claims, further comprising a gate runner (43) arranged in the edge termination region (210) and at least partly above the electrically conducting layer (60), and extending at least partly around the active region (220), wherein the electrically conducting layer (60) is electrically coupled to the gate runner (43) via a plurality of contact plugs (45).

6. The semiconductor device of claim 5, wherein the plurality of contact plugs (45) is arranged at regular intervals around the perimeter of the gate electrode (33), and wherein each of the plurality of contact plugs (45) is configured to extend between the gate runner (43) and the electrically conducting layer (60).

7. The semiconductor device of claim 5 or 6, further comprising a gate pad (46), wherein the gate runner (43) is electrically coupled to the gate pad (46).

8. The semiconductor device of any of the preceding claims, wherein the electrically conducting layer (60) comprises a polycrystalline semiconductor material.

9. The semiconductor device of any of any of the preceding claims, wherein the gate electrode (33) has a grid-like structure.

10. The semiconductor device of any of the preceding claims, wherein each of the plurality of transistor cells (30) further comprises a compensation region (38) of a doping type complementary to the doping type of the drift region (35) and extending from a respective body region (32) into the drift region (35) in the vertical direction.

11. A semiconductor device, comprising:

a semiconductor body (100) comprising a first surface (101), a second surface (102) opposite to the first surface (101) in a vertical direction, an edge termination region (210), and an active region (220) arranged adjacent to the edge termination region (210) in a horizontal direction;

a plurality of transistor cells (30) at least partly integrated in the active region (220), each transistor cell (30) comprising a source region (31), a body region (32), a drift region (35) separated from the source region (31) by the body region (32);

a gate electrode (33) arranged in the active region (220) and dielectrically insulated from the body regions (32) of the plurality of transistor cells (30);

an electrically conducting layer (60) arranged above the first surface (101) and in the edge termination region (210); and

a plurality of contact plugs (45), wherein the electrically conducting layer (60) extends around and electrically contacts the gate

electrode (33), each of the plurality of contact plugs (45) is configured to electrically contact the

electrically conducting layer (60), the plurality of contact plugs (45) comprises at least two sub-groups, each sub-group

comprising at least two contact plugs (45), two neighboring contact plugs (45) within each sub-group are arranged at a first

distance (d1) from each other along a perimeter of the gate electrode (33), and along the perimeter of the gate electrode (33) two neighboring sub-groups are separated

from each other by one of at least two contact plug free sections (70) comprising no contact plugs (45), each contact plug free section (70) having a length (d2n) along the perimeter of the gate electrode (33) that is greater than the first distance (d1).

12. The semiconductor device of claim 11, wherein the gate electrode (33) has a polygonal perimeter comprising at least four corners, wherein each of the at least two sub-groups of contact plugs (45) extends along a section of the perimeter of the gate electrode (33), and wherein at least one of the following

at least one of the contact plug free sections (70) is arranged at one of the at least four corners of the gate electrode (33); and

at least one of the contact plug free sections (70) extends along the perimeter of the gate electrode (33) between two of the at least four corners.

13. The semiconductor device of claim 11 or 12, further comprising a gate runner (43) arranged in the edge termination region (210) and at least partly above the electrically conducting layer (60), wherein each of the plurality of contact plugs (45) is configured to extend between the gate runner (43) and the electrically conducting layer (60).

14. The semiconductor device of any of claims 11 to 13, wherein
the semiconductor body (100) comprises first and second longitudinal sides (L1, L1) and first and second narrow sides (N1, N2); and
each of the at least two sub-groups of contact plugs (45) extends either parallel to the first and second longitudinal sides (L1, L1), or parallel to the first and second narrow sides (N1, N2).

15. The semiconductor device of any of claims 11 to 14, wherein the electrically conducting layer (60) comprises a polycrystalline semiconductor material.

A - A'

FIG 1

EP 3 817 066 A1

D○

3

$V_{DS}$

G○          S○

## FIG 2

$C_{GD}$        D○

3

$V_{DS}$

$R_{Gext}$

$C_{GS}$

G○          S○

## FIG 3

N1

46            33

60

L1          L2    100

Z

x          A   A'

C

C'   N2

## FIG 4

X1        X2

46

100

Z

x          A   A'

## FIG 5

A - A'

FIG 6

EP 3 817 066 A1

A - A'

FIG 7

**FIG 8A**

**FIG 8B**

**FIG 8C**

**FIG 8D**

**FIG 8E**

**FIG 8F**

**FIG 8G**

**FIG 8H**

**FIG 8I**

**FIG 9**

**FIG 10**

C - C'

220          210

41          43          101

51    70

31    32    33    34    60    100

35          105

36          110

y
└→z

**FIG 11**

C - C'

220          210

41          70  43

51          101

31    32    33    34    60    100

35          105

36          110

y
└→z

**FIG 12**

# FIG 13

# FIG 14

Europäisches
Patentamt

European
Patent Office

Office européen
des brevets

# EUROPEAN SEARCH REPORT

Application Number

EP 19 20 6084

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2011/210392 A1 (NAKATA SHUHEI [JP] ET AL) 1 September 2011 (2011-09-01) | 1-9 | INV. H01L29/423 |
| Y | * paragraph [0038] - paragraph [0093] * | 10 | H01L29/739 |
| A | * figures 1-8 * | 11-15 | H01L29/78 |
| | ----- | | H01L29/06 |
| X | US 2014/077232 A1 (HINO SHIRO [JP] ET AL) 20 March 2014 (2014-03-20) | 11-15 | H01L29/10 H01L29/40 |
| A | * paragraph [0024] - paragraph [0051] * | 1-10 | H01L29/417 |
| | * paragraph [0068] * | | |
| | * figures 1-4 * | | |
| | ----- | | |
| Y | US 2017/154992 A1 (WILLMEROTH ARMIN [DE] ET AL) 1 June 2017 (2017-06-01) | 10 | |
| | * paragraph [0024] - paragraph [0029] * | | |
| | ----- | | |

TECHNICAL FIELDS
SEARCHED (IPC)

H01L

The present search report has been drawn up for all claims

| Place of search | Date of completion of the search | Examiner |
|---|---|---|
| Munich | 24 March 2020 | Kostrzewa, Marek |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 19 20 6084

This annex lists the patent family members relating to the patent documents cited in the above-mentioned European search report.
The members are as contained in the European Patent Office EDP file on
The European Patent Office is in no way liable for these particulars which are merely given for the purpose of information.

24-03-2020

| Patent document cited in search report | | Publication date | Patent family member(s) | | Publication date |
|---|---|---|---|---|---|
| US 2011210392 | A1 | 01-09-2011 | CN | 102265404 A | 30-11-2011 |
| | | | DE | 112009004277 T5 | 04-10-2012 |
| | | | JP | 5529042 B2 | 25-06-2014 |
| | | | JP | 5789016 B2 | 07-10-2015 |
| | | | JP | 6172224 B2 | 02-08-2017 |
| | | | JP | 2014103425 A | 05-06-2014 |
| | | | JP | 2015216400 A | 03-12-2015 |
| | | | JP | WO2010073759 A1 | 14-06-2012 |
| | | | KR | 20110087337 A | 02-08-2011 |
| | | | US | 2011210392 A1 | 01-09-2011 |
| | | | WO | 2010073759 A1 | 01-07-2010 |
| US 2014077232 | A1 | 20-03-2014 | CN | 103548145 A | 29-01-2014 |
| | | | CN | 106252416 A | 21-12-2016 |
| | | | DE | 112012002603 T5 | 03-04-2014 |
| | | | JP | 5653519 B2 | 14-01-2015 |
| | | | JP | WO2012176503 A1 | 23-02-2015 |
| | | | US | 2014077232 A1 | 20-03-2014 |
| | | | WO | 2012176503 A1 | 27-12-2012 |
| US 2017154992 | A1 | 01-06-2017 | CN | 106992212 A | 28-07-2017 |
| | | | DE | 102015120747 A1 | 01-06-2017 |
| | | | US | 2017154992 A1 | 01-06-2017 |

EPO FORM P0459

For more details about this annex : see Official Journal of the European Patent Office, No. 12/82